# EUROPÄISCHE PATENTSCHRIFT

(11) **EP 1 183 545 B1**
(45) Veröffentlichungstag und Bekanntmachung des Hinweises auf die Patenterteilung: **13.08.2003**
(21) Anmeldenummer: 00929279.8
(22) Anmeldetag: 05.04.2000
(51) Int. Cl.: G01R 31/3185, G01R 31/3187

(54) **SCHALTUNG MIT EINGEBAUTEM SELBSTTEST**
CIRCUIT WITH BUILT-IN SELF-TESTER
CIRCUIT A AUTOTEST INTEGRE

(30) Priorität: 20.04.1999 DE 19917884
(43) Veröffentlichungstag der Anmeldung: 06.03.2002
(73) Patentinhaber: Infineon Technologies AG, 81669 München (DE)
(72) Erfinder: NOLLES, Jürgen, D-81541 München (DE); DIRSCHERL, Gerd, D-81543 München (DE); GÄRTNER, Wolfgang, D-80807 München (DE)
(74) Vertreter: Epping Hermann & Fischer
(86) Internationale Anmeldenummer: DE0001052
(87) Internationale Veröffentlichungsnummer: WO00063711

(56) Entgegenhaltungen:
- US-A- 5 383 195
- US-A- 5 416 783
- US-A- 5 872 793

## Beschreibung

Die Erfindung bezieht sich auf eine Schaltung mit eingebautem Selbsttest und insbesondere auf eine integrierte Schaltung in einer Chip-Karte mit verbesserten Testmöglichkeiten.

Insbesondere zum logischen Testen von integrierten Schaltungen werden herkömmlicherweise Software-Tests zum funktionalen Testen oder Hardware-Tests zum strukturellen Testen verwendet.

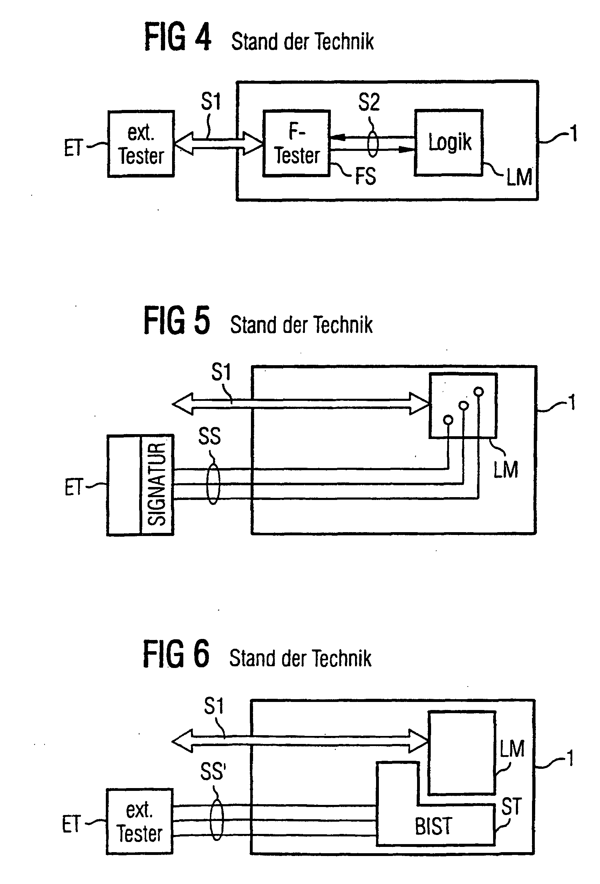

Figur 4 zeigt eine schematische Blockdarstellung einer Testanordnung zum Testen einer komplexen Schaltung 1 mit einem herkömmlichen Software-Test. In Figur 4 bezeichnet das Bezugszeichen ET ein externes Testgerät, das über eine Standard-Schnittstelle S1 mit der zu testenden komplexen Schaltung 1 in Verbindung steht. Die komplexe Schaltung 1 besteht im wesentlichen aus einer Funktionsschaltung FS, die zum einen der Ansteuerung einer eigentlichen Logikschaltung LM und zum anderen dem funktionalen Test der Logikschaltung LM dient. Die Funktionsschaltung FS ist mit der eigentlich zu testenden Logikschaltung LM über eine direkte Schnittstelle S2 verbunden, die im wesentlichen eine Verbindung zu den Einund Ausgängen der Logikschaltung LM darstellt. Üblicherweise besteht ein Testzugriff über eine derartige direkte Schnittstelle S2 nur über Register, weshalb sie auch als "Software-bzw. Register-Schnittstelle" bezeichnet wird. Zum Testen der komplexen Schaltung 1 sendet das externe Testgerät ET über die Standard-Schnittstelle S1 verschiedenste Testdaten an die Funktionsschaltung FS, welche einen funktionalen Test der Logikschaltung LM über die direkte Schnittstelle S2 durchführt.

Nachteilig ist bei diesem herkömmlichen Sofware-Test, bei dem lediglich ein funktionaler Test der Logikschaltung LM durchgeführt werden kann, die relativ geringe Testabdeckung von ca. 60 bis 70 Prozent. Dies liegt im wesentlichen daran, daß bestimmte interne Bereiche der Logikschaltung LM nicht durch diesen herkömmlichen funktionalen Test erreicht werden können.

Zur Verbesserung der Testabdeckung wurden daher Hardware-Tests entwickelt, die in Figur 5 und Figur 6 dargestellt sind.

Figur 5 zeigt eine schematische Blockdarstellung einer weiteren herkömmlichen Testanordnung, die über einen sogenannten Hardware-Test einen strukturellen Test einer zu testenden Schaltung ermöglicht. Gemäß Figur 5 besteht die zu testende kommplexe Schaltung 1 im wesentlichen aus einer Logikschaltung LM, die über eine Standard-Schnittstelle S1 mit der Auβenwelt in Verbindung steht. Im Gegensatz zum funktionalen Test gemäß Figur 4, bei dem der Test über die Standard-Schnittstelle S1 durchgeführt wird, besitzt die Testanordnung gemäß Figur 5 zusätzlich eine strukturelle Schnittstelle SS, die einen strukturellen Test der Logikschaltung LM ermöglicht. Zur Realisierung dieser strukturellen Schnittstelle SS werden üblicherweise fünf weitere Anschlußleitungen benötigt, die einen Eingangs- und Ausgangsanschluß, einen Takt- und Steueranschluß sowie einen Anschluß zum Aktivieren bzw. Deaktivieren der strukturellen Schnittstelle SS aufweist. Die strukturelle Schnittstelle SS führt hierbei in interne Bereiche der Logikschaltung LM, wodurch auch die für einen herkömmlichen funktionalen Test schwer zugänglichen Logikbereiche erreicht werden können. Bei dem herkömmlichen Test gemäß Figur 5 werden unter Berücksichtigung der technischen Besonderheiten der Logikschaltung LM optimierte Testmuster errechnet, die der Logikschaltung LM vom externen Testgerät ET über die strukturelle Schnittstelle SS zugeführt werden. Die Reaktion der Logikschaltung LM auf die Testmuster wird über die strukturelle Schnittstelle SS zum externen Testgerät ET geführt und dort verarbeitet. Auf diese Weise erhält man mittels einer geringen Anzahl von optimierten Testmustern eine außerordentlich hohe Testabdeckung von bis zu 100 %.

Nachteilig ist bei diesem herkömmlichen Testverfahren die zusätzliche strukurelle Schnittstelle SS, die einerseits Sicherheitsprobleme bei sensitiven Schaltungen und andererseits zusätzliche Hardware zum Betreiben der komplexen Schaltung 1 bedeutet. Ferner erhöht sich der für den Hardware-Test notwendige Flächenbedarf der komplexen Schaltung 1.

Figur 6 zeigt eine schematische Blockdarstellung einer weiteren herkömmlichen Testanordnung ,wobei zur Verringerung des Rechenaufwandes für die Bestimmung der optimierten Testmuster gemäß Figur 5 ein sogenannter BIST (built-in self test) verwendet wird. Die herkömmliche Testanordnung gemäß Figur 6 entspricht im wesentlichen der herkömmlichen Testanordnung gemäß Figur 5, wobei jedoch die komplexe Schaltung 1 einen eingebauten Selbsttest (BIST) als strukturelle Testeinrichtung ST aufweist. Zum Betreiben der Logikschaltung LM wird hierbei wiederum eine Standard-Schnittstelle S1 verwendet, während die eingebaute strukturelle Testeinrichtung ST über eine vereinfachte strukturelle Schnittstelle SS' mit einem externen Testgerät ET in Verbindung steht. Der in Figur 6 eingesetzte BIST besitzt üblicherweise einen sogenannten Pseudo-Zufallszahlengenerator zum schnellen Erzeugen von Testmustern. Dieser Pseudo-Zufallszahlengenerator erzeugt hierbei auf äußerst einfache Art und Weise eine Vielzahl von Testmustern, die der eigentlich zu testenden Logikschaltung LM über interne Zugangspunkte (scan path und/oder Testpunkte) zugeführt und die entsprechenden Ergebnis-Testmuster ausgewertet werden. Die Ergebnisvektoren werden dabei vorzugsweise in einem nicht dargestellten Signaturregister komprimiert und die so gewonnene Signatur mit einem Sollwert verglichen. Im Gegensatz zur Testanordnung gemäß Figur 5 sind diese vom Pseudo-Zufallszahlengenerator erzeugten Testmuster jedoch nicht auf die Logikschaltung LM optimiert, weshalb man eine typische Testabdeckung von ca. 80 Prozent erhält.

Nachteilig ist neben der geringeren Testabdeckung die Existenz der weiteren strukturellen Schnittstelle SS', die wiederum ein Sicherheitsproblem darstellt, sowie der außerordentlich hohe Flächenbedarf für die zusätzliche Hardware (BIST) in der komplexen Schaltung 1, der bis zu 10 Prozent des Gesamtflächenbedarfs für die komplexe Schaltung 1 beträgt.

Insbesondere bei integrierten Schaltungen, die in sogenannten Chip-Karten eingesetzt werden, stellt jedoch die Anzahl der externen Anschlüsse bzw. Schnittstellen ein großes Problem dar. Genauer gesagt besitzen derartige Chip-Karten bereits eine fest vorgegebenen Standard-Schnittstelle mit einer festen Anzahl von Anschlüssen, die nicht modifizierbar ist. Ferner stellt das Zurverfügungstellen einer weiteren Schnittstelle insbesondere bei sogenannten Geldwert-Karten ein Sicherheitsrisiko dar, welches nicht akzeptiert werden kann, da unerlaubte Manipulationen an der eigentlichen Logikschaltung zuverlässig auszuschalten sind.

Die US 5,872,793 beschreibt eine Schaltung, welche sowohl einen "boundary scan test" als auch einen eingebauten Selbsttest (BIST) ermöglicht und hierzu einen "clock multiplier" verwendet. Die US 5,416,783 beschreibt eine Schaltung, die auf die Datenkompression innerhalb eines eingebauten Selbsttestes (BIST) abstellt. Die US 5,383,195 beschreibt schließlich eine BIST-Schaltung, welche bei auftretenden Fehlern den Test anhält.

Der Erfindung liegt daher die Aufgabe zugrunde, eine Schaltung mit eingebautem Selbsttest zu schaffen, die bei Verwendung einer fest vorgegebenen externen Schnittstelle auf einfache Weise eine Verbesserung der Testabdeckung einer zu testenden Schaltung ermöglicht .

Erfindungsgemäß wird diese Aufgabe durch die im Patentanspruch 1 angegebenen Merkmale gelöst.

Insbesondere durch die Verwendung einer strukturellen Testeinrichtung und einer indirekten Schnittstelle zum Verbinden der strukturellen Testeinrichtung mit einer Funktionsschaltung der komplexen Schaltung kann die Testabdeckung für eine zu testende Logikschaltung verbessert werden, ohne dabei eine weitere externe Schnittstelle zu verwenden.

Vorzugsweise besitzt die strukturelle Testeinrichtung eine Abtastkette (scan path) und/oder Testpunkte, die sich unmittelbar in der zu testenden Logikschaltung befinden. Dadurch können auch Logikbereiche getestet werden, die über rein funktionale Tests nicht oder nur sehr schwer erreichbar sind. Die strukturelle Testeinrichtung kann hierbei optimierte Vektoren oder Pseudo-Zufallsvektoren als Testmuster verwenden. Der Grad der Testabdeckung kann auf diese Weise variabel bis zu fast 100 Prozent eingestellt werden.

Vorzugsweise verwendet die strukturelle Testeinrichtung als Testmuster Pseudo-Zufallsvektoren, mit einer Testabdeckung von ca. 80 Prozent, wobei die restlichen bis zu 20 Prozent Testabdeckung über einen funktionalen Test realisiert werden. Auf diese Weise erhält man auf besonders einfache und kostengünstige Weise eine außerordentlich hohe Testabdeckung.

Vorzugsweise besteht die zu testende Logikschaltung ferner aus einer Vielzahl von Logik-Modulen, die über die gleiche strukturelle
Testeinrichtung angesteuert wird, wodurch sich eine weitere Flächenersparnis und Vereinfachung der Testanordnung ergibt.

In den Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: eine schematische Blockdarstellung einer Testanordnung gemäß einem ersten erfindungsgemäßen Ausführungsbeispiel;
- Figur 2: eine schematische Blockdarstellung einer strukturellen Testeinrichtung in Verbindung mit einer zu testenden Logikschaltung;
- Figur 3: eine schematische Blockdarstellung einer Testanordnung gemäß einem zweiten erfindungsgemäßen Ausführungsbeispiel;
- Figur 4: eine schematische Blockdarstellung einer herkömmlichen Testanordnung;
- Figur 5: eine schematische Blockdarstellung einer weiteren herkömmlichen Testanordnung; und
- Figur 6: eine schematische Blockdarstellung einer weiteren herkömmlichen Testanordnung.

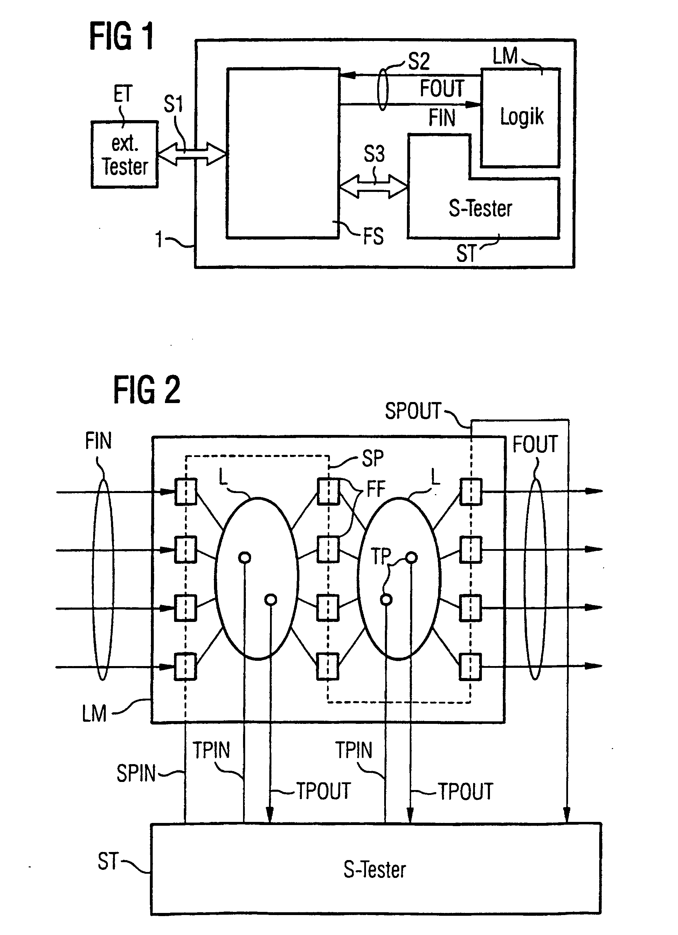

Figur 1 zeigt eine schematische Blockdarstellung einer Testanordnung mit einem externen Testgerät ET und einer komplexen Schaltung 1, die beispielsweise eine integrierte Schaltung in einer sogenannten Chip-Karte darstellt. Die komplexe Schaltung 1 besitzt eine Funktionsschaltung FS, eine strukturelle Testeinrichtung ST und eine Logikschaltung LM. Die Funktionsschaltung FS besteht im wesentlichen aus einer software, die beispielsweise von einem Mikroprozessor (CPU, usw.) abgearbeitet wird. Der Mikroprozessor wird hierbei ebenfalls durch die Funktionsschaltung FS (software) getestet und daher gemäß Fig. 1 dem Block der Logikschaltung LM zugeordnet. Die komplexe Schaltung 1 besitzt ferner eine fest vorgegebene Standard-Schnittstelle S1, über die sie mit nicht dargestellten externen Geräten in Verbindung tritt. Bei Chip-Karten besteht diese Standard-Schnittstelle S1 im wesentlichen aus fünf belegten Anschlußleitungen, die eine fest vorgegebene Funktionszuordnung aufweisen. Dadurch ist eine Kompatibilität mit einer Vielzahl von externen Schreib-/Lesegeräten sichergestellt. Da es sich bei den auf Chip-Karten abgelegten Daten oft um sicherheitsrelevante Daten handelt, besteht die Notwendigkeit, eine Manipulation dieser sicherheitsrelevanten Daten möglichst zu verhindern, weshalb ein direkter Zugriff auf die eigentliche Logikschaltung LM ausgeschlossen werden muß.

Die komplexe Schaltung 1 besitzt hierfür eine indirekte Schnittstelle S3, die die Funktionsschaltung FS mit der strukturellen Testeinrichtung ST verbindet. Wird beispielsweise von dem externen Testgerät ET über die Standard-Schnittstelle S1 bei der Funktionsschaltung FS ein Test für die Logikschaltung LM angefordert, so wird gemäß Figur 1 diese Testanforderung über die indirekte Schnittstelle S3 an die strukturelle Testeinrichtung ST weitergegeben, die einen strukturellen Test der Logikschaltung LM durchführt und das Testergebnis über die indirekte Schnittstelle S3 an die Funktionsschaltung FS zurückgibt. Die Funktionsschaltung FS gibt anschließend das Testergebnis über die Standard-Schnittstelle S1 an das externe Testgerät ET aus. Wird die komplexe Schaltung 1 demgegenüber an ein nicht dargestelltes externes Schreib-/Lesegerät angeschaltet, so werden die über die Standard-Schnittstelle S1 übertragenen Schreib-/Lesedaten von der Funktionsschaltung FS auf die direkte Schnittstelle S2 umgeleitet und von der Logikschaltung LM in herkömmlicher Weise verarbeitet.

Insbesondere durch die Verwendung der Funktionsschaltung FS als Schnittstellenwandler zwischen der fest vorgegebenen externen Standard-Schnittstelle S1 und der internen direkten Schnittstelle S2 und/oder indirekten Schnittstelle S3, sowie der Verwendung einer strukturellen Testeinrichtung ST erhält man eine Schaltung 1 mit eingebautem Selbsttest, die eine verbesserte Testabdeckung bei Verwendung der externen Standard-Schnittstelle S1 ermöglicht.

Die Figur 2 zeigt eine schematische Blockdarstellung der strukturellen Testeinrichtung ST in Verbindung mit der eigentlich zu testenden Logikschaltung LM. In Figur 2 bezeichnen FIN und FOUT die Ein-/Ausgangsanschlüsse der Logikschaltung LM, welche die direkte Schnittstelle S2 darstellen. Vorzugsweise handelt es sich bei dieser direkten Schnittstelle S2 bzw. bei FIN/FOUT um eine Software-Schnittstelle, die einen Zugriff auf die zu testende Logikschaltung LM nur über Register der Funktionsschaltung FS ermöglicht. Ferner besteht die Logikschaltung LM im wesentlichen aus Logikbereichen L, die über Flip-Flops FF miteinander und mit der direkten Schnittstelle S2 (FIN/FOUT) in Verbindung stehen. Zum Durchführen eines strukturellen Tests sind die Flip-Flops FF der Logikschaltung LM beispielsweise über eine Abtastkette SP (scan path) verbunden. Die Abtastkette SP besitzt einen Abtastketten-Eingang SPIN und einen Abtastketten-Ausgang SPOUT, die mit der strukturellen Testeinrichtung ST verbunden sind. Die strukturelle Testeinrichtung ST kann somit ihre Testmuster über die Abtastkette SP in interne Logikbereiche einschreiben und entsprechende Testergebnisse aus diesen Bereichen auslesen, wodurch sich die Testabdeckung außerordentlich verbessert. Alternativ zu diesen Abtastketten SP können von der strukturellen Testeinrichtung ST auch Testpunkte TP direkt angesteuert werden, die sich unmittelbar in den zu testenden Logikbereichen L befinden. Die Testmuster werden hierbei von der strukturellen Testeinrichtung ST über Testpunkteingänge TPIN den Logikbereichen L zugeführt und über Testpunktausgänge TPOUT ein entsprechendes Testergebnis ausgelesen. Auf diese Weise erhält man ebenfalls eine verbesserte Testabdeckung für die zu testende logische Schaltung LM. Ferner kann auch eine Kombination aus Abtastketten SP und Testpunkten TP zum Testen der logischen Schaltung LM verwendet werden, um eine weitere Verbesserung der Testabdeckung zu erhalten.

Die in den Figuren 1 und 2 dargestellte strukturelle Testeinrichtung kann zum Testen der Logikschaltung LM qualitativ unterschiedliche Testmuster verwenden. Diese Testmuster können zum einen aus einer geringen Anzahl von speziell ermittelten (optimierten) Testvektoren bestehen, die in Kenntnis der Logikschaltung LM, der strukturellen Testeinrichtung ST und der Abtastketten SP sowie der Testpunkte TP speziell optimiert werden. Derart optimierte Testvektoren haben den Vorteil, daß sie eine nahezu hundertprozentige Testabdeckung für die zu testende Logikschaltung LM aufweisen. Diese optimierten Testvektoren können beispielsweise in der Funktionsschaltung abgelegt sein und über die indirekte Schnittstelle S3 zur Verfügung gestellt werden, sie können jedoch auch über die Standard-Schnittstelle S1 vom externen Testgerät ET in die Funktionsschaltung FS einzeln oder paketweise geladen werden, um sie anschließend auf die Logikschaltung LM anzuwenden. Auf diese Weise kann die zu testende Logikschaltung LM zu einem späteren Zeitpunkt auf besonders effektive Art und Weise unter Verwendung von optimierten Testvektoren getestet werden.

Alternativ kann jedoch die strukturelle Testeinrichtung auch sogenannte Pseudo-Zufallsvektoren verwenden, die von einem relativ leicht zu realisierenden Pseudo-Zufallszahlengenerator (nicht dargestellt) in der strukturellen Testeinrichtung ST erzeugt werden und eine außerordentlich große Menge von pseudo-zufälligen Testvektoren erzeugt. Derartige Pseudo-Zufallszahlengeneratoren werden beispielsweise in sogenannten BISTs (built-in self test) verwendet. Aufgrund ihrer nicht optimierten Struktur besitzen derartige Pseudo-Zufallsvektoren jedoch nur eine Testabdeckung von typischerweise ca. 80 Prozent.

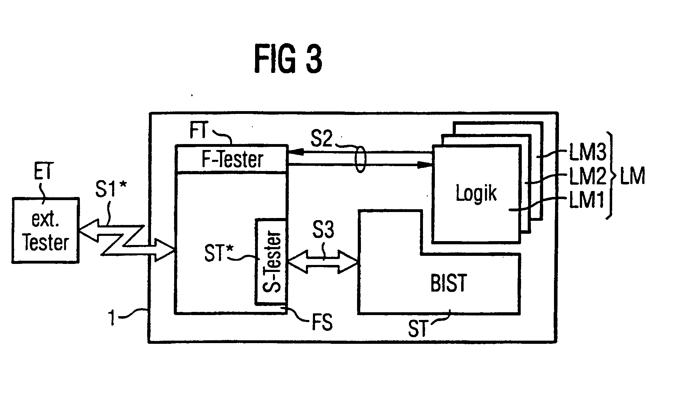

Die Figur 3 zeigt eine schematische Blockdarstellung einer Testanordnung gemäß einem zweiten Ausführungsbeispiel, wobei für die strukturelle Testeinrichtung ST ein derartiger BIST mit Pseudo-Zufallszahlengenerator verwendet wird.

Zur Verbesserung der Testabdeckung mit einem derartigen BIST (ca. 80 Prozent) kann beispielsweise die Schaltung der strukturellen Testeinrichtung ST gemeinsam mit der Logikschaltung LM simuliert und die restlichen ca. 20 Prozent der noch fehlenden Testabdeckung qualitativ lokalisiert werden. Auf der Grundlage eines derartigen Simulationsergebnisses kann anschließend ein funktionaler Test als Software-Test erzeugt und in der Funktionsschaltung FS angewendet werden. Das Bezugszeichen FT bezeichnet eine derartige funktionale Testeinrichtung, die über die direkte Schnittstelle S2 einen gezielten funktionalen Test der restlichen ca. 20 Prozent durchführt. Auf diese Weise erhält man durch Kombination der strukturellen Testeinrichtung ST mit einer funktionalen Testeinrichtung FT eine weitere Verbesserung der Testabdeckung.

Gemäß Figur 3 können ferner Teile der strukturellen Testeinrichtung ST in der Funktionsschaltung FS ausgelagert und softwaremäßig realisiert werden. In Figur 3 werden derartige ausgelagerte Teile der strukturellen Testeinrichtung ST mit ST* bezeichnet, wobei der ausgelagerte strukturelle Testteil ST* über die indirekte Schnittstelle S3 mit der strukturellen Testeinrichtung ST in Verbindung steht. Derartige ausgelagerte strukturelle Testteile ST* sind beispielsweise die Testdauer, wobei ein hardwaremäßig realisierter Zähler durch eine softwaremäßige Schleife in der Funktionsschaltung FS ersetzt wird. Ferner kann der in der strukturellen Testeinrichtung ST vorhandene Soll-Ist-Wert-Komparator durch einen Softwarevergleich in der Funktionsschaltung FS realisiert werden. Theoretisch sind alle BIST-Funktionen bis auf die eigentlichen Abtastketten (scan path) SP und Testpunkte TP softwaremäßig im strukturellen Testteil ST* der Funktionsschaltung FS realisierbar, wodurch sich eine weitere Flächenersparnis für die komplexe Schaltung 1 ergibt.

Ferner kann gemäß Figur 3 die Logikschaltung LM aus einer Vielzahl von Logik-Modulen LM1, LM2, LM3 bestehen, wobei eine einzige strukturelle Testeinrichtung ST für alle zu testenden Logik-Module LM1, LM2 und LM3 verwendet wird. Insbesondere bei Verwendung eines BIST mit Pseudo-Zufallszahlengenerator können somit unterschiedliche Logik-Module auf besonders einfache Weise getestet werden. Vorzugsweise wählt hierbei die Funktionsschaltung FS ein jeweiliges Logikmodul aus, für welches ein Test durchzuführen ist. Auf diese Weise ist auch ein paralleler Test von zwei oder mehreren Logik-Modulen LM1, LM2 und LM3 möglich.

Ferner kann gemäß Figur 3 als Standard-Schnittstelle eine berührungslose bzw. kontaktlose Standard-Schnittstelle S1* zur Übertragung der Daten zu einem externen Gerät ET verwendet werden, wobei die komplexe Schaltung 1 ferner eine nicht dargestellte Sende-/Empfangseinrichtung zum Betreiben dieser berührungslosen Standard-Schnittstelle S1* aufweist.

Die Erfindung wurde vorstehend anhand einer integrierten Schaltung in einer Chip-Karte beschrieben. Sie ist jedoch nicht darauf beschränkt und ist vielmehr auf alle komplexen Schaltungen anzuwenden, die eine fest vorgegebene Standard-Schnittstelle aufweisen und einen Selbsttest mit verbesserter Testabdeckung benötigen.

## Patentansprüche

1. Schaltung mit eingebautem Selbsttest bestehend aus: einer zu testenden Logikschaltung (LM), und
einer Funktionsschaltung (FS) zum Betreiben der Logikschaltung (LM) über eine direkte Schnittstelle (S2), wobei die Funktionsschaltung (FS) eine Standard-Schnittstelle (S1) zum Verbinden der Schaltung (1) mit einem externen Gerät (ET) aufweist, **gekennzeichnet durch**
eine strukturelle Testeinrichtung (ST) zum strukturellen Testen der Logikschaltung (LM), und
eine indirekte Schnittstelle (S3) zum indirekten Betreiben der Logikschaltung (LM), wobei die Funktionsschaltung (FS) die an der Standard-Schnittstelle (S1) anliegenden Testbefehle zumindest teilweise an die indirekte Schnittstelle (S3) weitergibt.

2. Schaltung nach Patentanspruch 1,
**dadurch gekennzeichnet, daß** die strukturelle Testeinrichtung (ST) eine Abtastkette (SP) und/oder Testpunkte (TP) in der zu testenden Logikschaltung (LM) aufweist.

3. Schaltung nach Patentanspruch 1 oder 2,
**dadurch gekennzeichnet, daß** die strukturelle Testeinrichtung (ST) Testmuster in Form von auf die zu testende Logikschaltung (LM) optimierten Vektoren verwendet, die in der Funktionsschaltung (FS) abgelegt sind.

4. Schaltung nach Patentanspruch 3,
**dadurch gekennzeichnet, daß** die in der Funktionsschaltung (FS) abgelegten Testmuster über die Standard-Schnittstelle (S1) aus einem externen Tester (ET) ladbar sind.

5. Schaltung nach Patentanspruch 1 oder 2,
**dadurch gekennzeichnet, daß** die strukturelle Testeinrichtung (ST) einen Testmuster-Generator zum Erzeugen eines Testmusters in Form von Pseudo-Zufallsvektoren aufweist.

6. Schaltung nach einem der Patentansprüche 1 bis 5,
**dadurch gekennzeichnet, daß** die Funktionsschaltung (FS) eine funktionale Testeinrichtung (FT) zum funktionalen Testen der Logikschaltung (LM) über die direkte Schnittstelle (S2) aufweist.

7. Schaltung nach Patentanspruch 6,
**dadurch gekennzeichnet, daß** die funktionale Testeinrichtung (FT) den funktionalen Test auf der Grundlage eines Simulationsergebnisses für die strukturelle Testeinrichtung (ST) und die Logikschaltung (LM) durchführt.

8. Schaltung nach einem der Patentansprüche 5 bis 7,
**dadurch gekennzeichnet, daß** ein Teil (ST*) der strukturellen Testeinrichtung softwaremäßig in der Funktionsschaltung (FS) realisiert ist.

9. Schaltung nach einem der Patentansprüche 1 bis 8,
**dadurch gekennzeichnet, daß** die zu testende Logikschaltung eine Vielzahl von Logik-Modulen (LM1, LM2, LM3) aufweist.

10. Schaltung nach Patentanspruch 9,
**dadurch gekennzeichnet, daß** die Funktionsschaltung (FS) einen oder mehrere aus der Vielzahl von Logik-Modulen (LM1, LM2, LLM3) zum Testen auswählt.

11. Schaltung nach einem der Patentansprüche 1 bis 10,
**dadurch gekennzeichnet, daß** die Schaltung (1) eine integrierte Schaltung auf einer Chip-Karte darstellt.

12. Schaltung nach einem der Patentansprüche 1 bis 11,
**dadurch gekennzeichnet, daß** die Standard-Schnittstelle eine berührungslose Schnittstelle (S1*) darstellt.

## Claims

1. Circuit with built-in self-test comprising:
a logic circuit (LM) to be tested, and
a functional circuit (FS) for operating the logic circuit (LM) via a direct interface (S2), the functional circuit (FS) having a standard interface (S1) for connecting the circuit(1) to an external unit (ET), **characterized by**
a structural test device (ST) for the structural testing of the logic circuit (LM), and
an indirect interface (S3) for the indirect operation of the logic circuit (LM), the functional circuit (FS) forwarding the test commands present at the standard interface (S1) at least in part to the indirect interface (S3).

2. Circuit according to Patent Claim 1,
**characterized in that** the structural test device (ST) has a scan path (SP) and/or test points (TP) in the logic circuit (LM) to be tested.

3. Circuit according to Patent Claim 1 or 2,
**characterized in that** the structural test device (ST) uses test patterns in the form of vectors which are optimized to the logic circuit (LM) to be tested and are stored in the functional circuit (FS).

4. Circuit according to Patent Claim 3,
**characterized in that** the test patterns stored in the functional circuit (FS) can be loaded via the standard interface (S1) from an external tester (ET).

5. Circuit according to Patent Claim 1 or 2,
**characterized in that** the structural test device (ST) has a test pattern generator for generating a test pattern in the form of pseudo-random vectors.

6. Circuit according to one of Patent Claims 1 to 5,
**characterized in that** the functional circuit (FS) has a functional test device (FT) for the functional testing of the logic circuit (LM) via the direct interface (S2).

7. Circuit according to Patent Claim 6,
**characterized in that** the functional test device (FT) carries out the functional test on the basis of a simulation result for the structural test device (2) and the logic circuit (LM).

8. Circuit according to one of Patent Claims 5 to 7,
**characterized in that** a part (ST*) of the structural test device is realized as software in the functional circuit (FS).

9. Circuit according to one of Patent Claims 1 to 8,
**characterized in that** the logic circuit to be tested has a multiplicity of logic modules (LM1, LM2, LM3).

10. Circuit according to Patent Claim 9,
**characterized in that** the functional circuit (FS) selects one or more from the multiplicity of logic modules (LM1, LM2, LM3) for testing.

11. Circuit according to one of Patent Claims 1 to 10,
**characterized in that** the circuit (1) constitutes an integrated circuit on a smart card.

12. Circuit according to one of Patent Claims 1 to 11,
**characterized in that** the standard interface constitutes a contactless interface (S1*).

## Revendications

1. Circuit à autotest intégré constitué de :
un circuit (LM) logique à tester, et
un circuit (FS) de fonction destiné à faire fonctionner le circuit (LM) logique pas l'intermédiaire d'un interface (S2) direct, le circuit (FS) de fonction comprenant un interface (S1) standard destiné à relier le circuit (1) à un appareil (ET) extérieur, **caractérisé par**
un dispositif (ST) de test structurel destiné à tester structurellement le circuit (LM) logique, et
un interface (S3) indirect destiné à faire fonctionner indirectement le circuit (LM) logique, le circuit (FS) de fonction transmettant les ordres de test s'appliquant à l'interface (SI) standard, au moins en partie à l'interface (S3) indirect.

2. Circuit suivant la revendication 1, **caractérisé en ce que** le dispositif (ST) de test structurel comporte une chaîne (SP) d'échantillonnage et/ou des points (TP) de test dans le circuit (LM) logique à tester.

3. Circuit suivant la revendication 1 ou 2, **caractérisé en ce que** le dispositif (ST) de test structurel utilise des modèles de test sous la forme de vecteurs optimisés sur le circuit (LM) logique à tester et mémorisés dans le circuit (FS) de fonction.

4. Circuit suivant la revendication 3, **caractérisé en ce que** les modèles de test mémorisés dans lé circuit (FS) de fonction peuvent être chargés par l'interface (SI) standard à partir d'un appareil (ET) extérieur de test.

5. Circuit suivant la revendication 1 ou 2, **caractérisé en ce que** le dispositif (ST) de test structurel comprend un générateur de modèle de test destiné à produire un modèle de test sous la forme de vecteurs pseudo-aléatoires.

6. Circuit suivant l'une des revendications 1 à 5, **caractérisé en ce que** le circuit (FS) de fonction comprend un dispositif (FT) de test fonctionnel destiné à tester fonctionnellement le circuit (LM) logique par l'interface (S2) direct.

7. Circuit suivant la revendication 6, **caractérisé en ce que** le dispositif (FT) de test fonctionnel effectue le test fonctionnel sur la base d'un résultat de simulation pour le dispositif (ST) de test structurel et le circuit (LM) logique.

8. Circuit suivant l'une des revendications 5 à 7, **caractérisé en ce qu'**une partie (ST*) du dispositif de test structurel est réalisée en logiciel dans le circuit (FS) de fonction.

9. Circuit suivant l'une des revendications 1 à 8, **caractérisé en ce que** le circuit logique à tester comporte une pluralité de modules (LM1, LM2, LM3) logiques.

10. Circuit suivant la revendication 9, **caractérisé en ce que** le circuit (FS) de fonction choisit un ou plusieurs modules (LM1, LM2, LM3) logiques parmi une pluralité pour effectuer le test.

11. Circuit suivant l'une des revendications 1 à 10, **caractérisé en ce que** le circuit (1) constitue un circuit intégré sur une carte à puce.

12. Circuit suivant l'une des revendications 1 à 11, **caractérisé en ce que** l'interface standard constitue un interface (S1*) sans contact.
